# EUROPEAN PATENT APPLICATION

(11) **EP 3 486 626 A1**
(43) Date of publication of application: **22.05.2019**
(21) Application number: 16908872.1
(22) Date of filing: 15.07.2016
(51) Int. Cl.: G01K 7/02, C04B 35/563, C04B 35/58

(54) **THERMOCOUPLE**

(71) Applicant: Miyagawa Kasei Industry Co., Ltd., Osaka-shi, Osaka 5330004 (JP)
(72) Inventor: KATOGI, Ken, Osaka 599-0301 (JP); ANO, Kiyoshi, Osaka-shi Osaka 533-0004 (JP); UESUGI, Naoki, Osaka-shi Osaka 533-0004 (JP); IKEGAWA, Mai, Osaka-shi Osaka 533-0004 (JP)
(74) Representative: Boult Wade Tennant LLP
(86) International application number: PCT/JP2016/070967
(87) International publication number: WO 2018/011971

(57) **Abstract**

A thermocouple is provided that can measure a temperature of a material in a high temperature range of 1500°C or higher with high accuracy at low cost. The thermocouple includes a first conductive member (1) and a second conductive member (2). The first conductive member (1) and the second conductive member (2) are connected to each other to form a temperature sensing junction. The first conductive member (1) contains a first conductive ceramic containing zirconium diboride and/or titanium diboride silicon carbide, a sintering agent, and unavoidable impurities. In the first conductive ceramic, the content of the silicon carbide is 5 mass% or more and 40 mass% or less. The second conductive member (2) contains a second conductive ceramic containing boron carbide as a main constituent material.

## Description

### TECHNICAL FIELD

The present invention relates to thermocouples, and more particularly, to a thermocouple containing conductive ceramics as a material for a temperature sensing junction of the thermocouple.

### BACKGROUND ART

Examples of the method of measuring a temperature of high-temperature molten metal exceeding 1500°C, such as steel smelting, include direct temperature measurement and indirect temperature measurement. Commonly adopted as the direct temperature measurement is a method of loading a thermocouple into a heat-resistant protecting tube and immersing the heat resistant protecting tube in molten metal in its entirety. This is because the surface of the molten metal is covered thickly with an oxide referred to as slag during metal smelting, making it difficult to measure the temperature of the molten metal by the indirect temperature measurement method with, for example, a radiation thermometer.

For direct temperature measurement, commonly used as the heat-resistant protecting tube is a refractory. Used as the refractory is, for example, alumina (Al₂O₃) or quartz.

Japanese Patent Laying-Open No. 2001-153730 describes a protecting tube for covering a thermocouple, which is a ceramic protecting tube made of alumina.

### CITATION LIST

### PATENT LITERATURE

PTL 1: Japanese Patent Laying-Open No. 2001-153730

### SUMMARY OF INVENTION

### TECHNICAL PROBLEM

When the temperature of high-temperature molten metal is measured continuously for a long period of time, however, the heat-resistant protecting tube is required to have a great thickness, normally several centimeters, for sufficient durability. In this case, the temperature measured by the thermocouple loaded in the heat-resistant protecting tube is equal to a temperature at a temperature measurement portion (temperature sensing junction) of the thermocouple after heat transfer from the molten metal via the refractory to the temperature sensing junction. As a result, even when a material having a relatively high thermal conductivity, for example, alumina graphite is used as a refractory, the measured temperature may be lower than the actual temperature of the molten metal. Also, in this case, there is a time delay due to heat transfer. This does not allow variations with time in the temperature of the molten metal to be followed promptly, making it difficult to perform real-time temperature measurement accurately.

When direct temperature measurement of high-temperature molten metal is performed with high accuracy, a method involving the use of a thin quartz tube which has a thickness of, for example, several millimeters as a heat-resistant protecting tube is adopted. In this case, though temperature measurement is performed with high accuracy, the time of endurance of the heat-resistant protecting tube is short, for example, several seconds, resulting in so-called spot temperature measurement. This requires repetitive measurements to observe variations with time in the molten metal. Although such temperature measurements involve the use of a thermocouple of platinum (Pt)-platinum-rhodium (PtRh), which is commonly classified as type R thermocouple in the JIS standard, such a thermocouple is expensive and costly to perform temperature measurement.

The present invention has been made to solve the above problems. A main object of the present invention is to provide a thermocouple capable of measuring the temperature of a material in a high temperature range of 1500°C or higher with high accuracy at low cost.

### SOLUTION TO PROBLEM

A thermocouple according to the present invention includes a first conductive member and a second conductive member. The first conductive member and the second conductive member are connected to each other to form a temperature sensing junction. The first conductive member contains a first conductive ceramic containing zirconium diboride and/or titanium diboride, silicon carbide, a sintering agent, and unavoidable impurities. In the first conductive ceramic, a content of the silicon carbide is 5 mass % or more and 40 mass% or less. The second conductive member contains a second conductive ceramic containing boron carbide as a main constituent material.

In the second conductive ceramic, a content of the boron carbide is preferably 50 mass% or more.

In the second conductive ceramic, a content of the boron carbide is preferably 70 mass% or more.

The second conductive ceramic preferably contains the boron carbide and unavoidable impurities.

The thermocouple further includes, in a region other than the temperature sensing junction, an insulating member insulating the first conductive member and the second conductive member from each other. The material for the insulating member may include zirconium oxide and/or zircon.

### ADVANTAGEOUS EFFECTS OF INVENTION

The present invention can provide a thermocouple capable of measuring a temperature of a material in a high temperature range with high accuracy at low cost.

### BRIEF DESCRIPTION OF DRAWINGS

Fig. 1 is a sectional view for illustrating a thermocouple according to Embodiment 1.
Fig. 2 is a sectional view taken along line segment II-II in Fig. 1.
Fig. 3 is a sectional view for illustrating a thermocouple according to Embodiment 2.
Fig. 4 is a view for illustrating an example configuration of the thermocouple according to Embodiment 1.
Fig. 5 is a view for illustrating an example configuration of the thermocouple according to Embodiment 1.
Fig. 6 is a view for illustrating an example configuration of the thermocouple according to Embodiment 1.
Fig. 7 is a graph showing thermoelectromotive forces of a sample 1, a sample 2, and a sample 3 of Example 1.
Fig. 8 is a graph showing a thermoelectromotive force of a sample 5 of Example 1.
Fig. 9 is a graph showing a thermoelectromotive force of a sample 4 of Example 1.
Fig. 10 is a graph showing thermoelectromotive forces of a sample 19 and a sample 20 of Example 3.
Fig. 11 is a graph showing thermoelectromotive forces of sample 19, a sample 21, and a sample 22 of Example 3.
Fig. 12 is a partially enlarged view of the graph shown in Fig. 11.

### DESCRIPTION OF EMBODIMENTS

Embodiments of the present invention will be described below with reference to the drawings. It should be noted that in the following drawings, the same or corresponding parts are denoted by the same reference numerals, and the description thereof will not be repeated.

### [Embodiment 1]

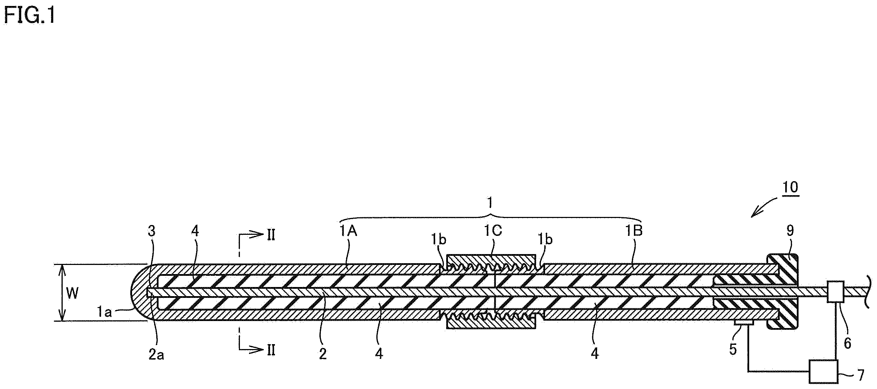

With reference to Fig. 1, a thermocouple 10 according to Embodiment 1 will be described. Thermocouple 10 is configured such that a first conductive member 1 and a second conductive member 2 form a temperature sensing junction.

First conductive member 1 is a member directly or indirectly exposed to a temperature sensing object whose temperature is measured by thermocouple 10, such as molten metal and is, for example, a conductive member obtained by molding a first conductive ceramic into a one-end-closed tube. Herein, "being directly exposed to a temperature sensing object" refers to a state in which first conductive member 1 forms the outermost surface of thermocouple 10, and "being indirectly exposed to a temperature sensing object" refers to a state in which first conductive member 1 is exposed to a temperature sensing object with a protective film therebetween (see Embodiment 2).

Second conductive member 2 is a member disposed inside first conductive member 1 formed as a one-end-closed tube and is, for example, a conductive member obtained by, for example, linearly molding a second conductive ceramic, which contains a material different from that of the first conductive member.

The first conductive ceramic contains zirconium diboride (ZrB₂), silicon carbide (SiC), a sintering agent, and unavoidable impurities. The content of silicon carbide (SiC) in the first conductive ceramic is 5 mass% or more and 40 mass% or less, and is preferably 5 mass% or more and 30 mass% or less, is more preferably 5 mass% or more and 20 mass% or less when the silicon carbide is used in a member that comes into direct contact with molten steel. The first conductive ceramic contains, for example, boron carbide (B₄C) as a sintering agent. The content of boron carbide (B₄C) in the first conductive ceramic is, for example, 1 mass%.

The first conductive ceramic mainly contains ZrB₂. ZrB₂ forms the first conductive ceramic other than SiC and B₄C, and the content of ZrB₂ is about 59 mass% or more and 94 mass% or less.

The theoretical density ratio of the first conductive ceramic is 90% or more, is preferably 94% or more. Herein, the theoretical density ratio refers to a value obtained by dividing the bulk specific gravity of the first conductive ceramic by the true specific gravity thereof. According to the definition of JIS R 1600, the bulk specific gravity (bulk density) is a value ρ₁·W₁/(W₃-W₂) obtained by multiplying a value W₁/(W₃-W₂) by a density ρ₁ of a medium solution. Value W₁/(W₃-W₂) is obtained by dividing a dry mass W₁ (g) of a ceramic sample by a value obtained by subtracting a mass in water W₂ (g) of the sample from a water-saturated mass W₃ (g) of the sample. The true specific gravity (true density) is a volume occupied by a ceramic material itself excluding the volume of a closed space inside the ceramic sample, which is a theoretical value calculated by the method in accordance with JIS R 2205. That is to say, the volume of holes is small inside the first conductive ceramic.

ZrB₂ has a melting point of 3246°C. This is higher than the temperature of a common molten metal. The thermal conductivity of ZrB₂ is about 100 W/(m·K). The electric conductivity of ZrB₂ is 10⁷ S/m or more, which is equal to that of carbon steel. SiC has a melting point of 2730°C. The thermal conductivity of SiC is about 70 W/(m·K). On the other hand, SiC has high electric resistance and exhibits semiinsulating properties. The unavoidable impurities are, for example, hydrogen (H), nitrogen (N), oxygen (O), or boron (B).

The main constituent material of the second conductive ceramic is boron carbide (B₄C). The content of B₄C in the second conductive ceramic is 50 mass% or more and may be 70 mass% or more. In this case, the second conductive ceramic may further contain, for example, at least one of ZrB₂, SiC, and zirconium carbide (ZrC), in addition to B₄C. Alternatively, the second conductive ceramic may contain B₄C and unavoidable impurities.

When the second conductive ceramic contains, for example, ZrB₂ having electric characteristics (such as electric resistance and thermoelectromotive force) different from those of B₄C, the electric characteristics of the second conductive ceramic can be adjusted by the content of ZrB₂.

When the second conductive ceramic includes various carbides free from boron, such as SiC or ZrC, a difference in the concentration of boron (B) between the second conductive ceramic and the first conductive ceramic can be reduced. Specifically, the B concentrations of ZrB₂ that is a main constituent material of the first conductive ceramic and B₄C that is a main constituent material of the second conductive ceramic are about 19 mass% and about 78 mass%, which greatly differ from each other. In this case, when thermocouple 10 containing the first conductive ceramic and the second conductive ceramic has been left for several tens of hours or more at a high temperature of about 1600°C, boron (B) atoms are diffused from the second conductive ceramic having a high B concentration to the first conductive ceramic having a low B concentration, which may change the electric characteristics of thermocouple 10. A diffusion rate at this time is proportional to a difference in B concentration according to the Fick's law. Thus, when the second conductive ceramic contains a carbide free from boron, such as SiC or ZrC, the B concentration in the second conductive ceramic can be reduced to be low compared with, for example, the second conductive ceramic containing ZrB₂, leading to a reduced diffusion rate. It is conceivable that when the second conductive ceramic contains SiC, ZrC, or the like, the thermoelectromotive force decreases more than when the second conductive ceramic contains ZrB₂ and when the second conductive ceramic contains B₄C and unavoidable impurities. Thus, an additive amount needs to be determined in consideration of both life and thermoelectromotive force. Herein, the life refers to a time until the accuracy of temperature measurement falls below a required value due to a decrease in thermoelectromotive force associated with the diffusion of B atoms, and the life of thermocouple 10 needs to be equal to or more than a period of time (e.g., furnace life) when the temperature of an object needs to be measured continuously. That is to say, thermocouple 10 needs to have a temperature measurement error after a lapse of the required time, which is regulated to be equal to or less than an acceptable maximum temperature measurement error. A desired value of the accuracy of measuring the temperature of thermocouple 10 and a period of time when continuous temperature measurement is required differ depending on a mode of use of thermocouple 10, and accordingly, the preferable range of the B concentration in the second conductive ceramic differs according to the mode of use of thermocouple 10.

The second conductive ceramic preferably contains no oxide in terms of reducing oxidation of boron contained in the second conductive ceramic. For example, when the second conductive ceramic contains an oxide such as alumina (Al₂O₃) and magnesia (MgO), boron contained in the second conductive ceramic undergoes oxidation. In this case, if the second conductive ceramic contains a small content of oxide, the thermoelectromotive force of thermocouple 10 decreases greatly along with the progress of oxidation. If the content of oxide increases, a low-melting oxide such as B₂O₃ is produced, and also, CO gas is generated, leading to collapse of the second conductive ceramic.

First conductive member 1 is formed of a body 1A, a plurality of extensions 1B, and a connecting portion 1C connected to each other. Connecting portion 1C couples body 1A and extensions 1B to each other.

Body 1A is made of first conductive ceramic, with one end configured as a closed end 1a and the other end configured as an open end 1b. A groove 3 provided to allow an end 2a of second conductive member 2 to be fixed thereto is formed inside closed end 1a. For example, groove 3 may be configured as a female screw hole, and end 2a of second conductive member 2 may be configured as a male screw, so that groove 3 and end 2a can be configured to be screwed. Fixing end 2a of second conductive member 2 to groove 3 of closed end 1a forms a temperature sensing junction of thermocouple 10 in closed end 1a. Open end 1b is configured as a male screw. The axial length of body 1A can be, for example, about 100 mm or more and 150 mm or less. The outside diameter of body 1A is, for example, 10 mm or more and 20 mm or less. The inside diameter of body 1A is greater than the hole diameter of groove 3 and is, for example, 6 mm or more and 15 mm or less. The wall surface of body 1A configured as a one-end-closed tube has a thickness of, for example, 1 mm or more and 5 mm or less.

Extension 1B is made of the first conductive ceramic and has opposite ends configured as open ends 1b. Open end 1b of extension 1B is configured as a male screw, similarly to open end 1b of body 1A. The axial length, thickness perpendicular to the axial direction, outside diameter, and inside diameter of extension 1B are provided similarly to those of body 1A.

Connecting portion 1C is made of the first conductive ceramic and is configured as a female screw that can be screwed with open end 1b of body 1A and open end 1b of extension 1B. Both of the materials for extension 1B and connecting portion 1C preferably contain the first conductive ceramic identical to that for body 1A.

First conductive member 1 assembled by screwing body 1A, extension 1B, and connecting portion 1C forms a one-end-closed tube in its entirety as described above. In first conductive member 1, the open end (one end of extension 1B) opposite to closed end 1a is closed by a plug 9. Plug 9 is made of a material having electrical insulating characteristics. Plug 9 is preferably made of a material having high thermal conductivity, and the material for plug 9 is, for example, aluminum nitride (AlN). Although first conductive member 1 has a temperature higher than that of second conductive member 2 because it is located outside of second conductive member 2, configuring plug 9 using a material having high thermal conductivity can sufficiently reduce a temperature difference between electrode pad 5 electrically and thermally connected to first conductive member 1 and electrode pad 6 electrically and thermally connected to second conductive member 2. This results in a sufficiently reduced measurement error of thermocouple 10.

Plug 9 has a through-hole formed for introducing second conductive member 2 from outside to inside of first conductive member 1. Second conductive member 2 is configured to extend from the through-hole of plug 9 through a space defined inside first conductive member 1 to groove 3 of closed end 1a. As described above, end 2a of second conductive member 2 is configured as, for example, a male screw.

In thermocouple 10, first conductive member 1 made of the first conductive ceramic is configured as one conductor forming a temperature sensing junction and is also configured as a heat-resistant protecting tube of second conductive member 2 which is the other conductor.

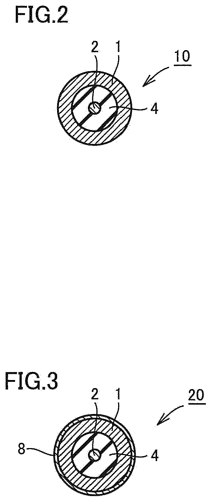

With reference to Fig. 2, insulating member 4 is charged into first conductive member 1 to surround second conductive member 2. It suffices that insulating member 4 is made of any material having insulating properties, having a high melting point, and unreactive to first conductive member 1 and second conductive member 2 in the temperature range in which thermocouple 10 is used. The material for insulating member 4 is, for example, zirconium oxide (ZrO₂) and/or zircon (ZrSiO₄). Although insulating member 4 may be configured by being filled with powdered ZrO₂ or the like, it may be filled with ZrO₂ or the like that has been preliminarily molded into a cylinder. Consequently, inside first conductive member 1, first conductive member 1 and second conductive member 2 are insulated from each other by ZrO₂ in the region other than the temperature sensing junction (closed end 1a).

First conductive member 1 and second conductive member 2 are connected with electrode pads 5 and 6, respectively. Electrode pads 5 and 6 are connected to the positions of first conductive member 1 and second conductive member 2, respectively, which have a predetermined temperature difference from the temperature sensing junction. Electrode pads 5 and 6 are connected with a measurement circuit (voltmeter) 7 that measures a potential difference between first conductive member 1 and second conductive member 2. That is to say, first conductive member 1, second conductive member 2, and measurement circuit 7 form a closed circuit. Consequently, the temperature at the temperature sensing junction of thermocouple 10 can be measured as a thermoelectromotive force.

First conductive member 1 may include a plurality of extensions 1B and a connecting portion 1C. Although thermocouple 10 is attached to, for example, pass through a ladle wall in a steel making process, at this time, any appropriate configuration of first conductive member 1 can be selected in accordance with a distance from the ladle wall to the temperature sensing junction of thermocouple 10.

A method of producing a first conductive ceramic will now be described. The method of producing a first conductive ceramic includes the step (S10) of mixing ZrB₂ powder, SiC powder, and a sintering agent, the step (S20) of adding a binder to a mixture obtained in the mixing step (S10) and kneading the mixture while heating, the step (S30) of molding a kneaded material obtained in the kneading step (S20), the step (S40) of degreasing a compact obtained in the molding step (S30), and the step (S50) of calcining a degreased material obtained in the degreasing step (S40).

First, in the step (S10), powdered ZrB₂ and powdered SiC are prepared. Further, B₄C powder is prepared as the sintering agent, and an organic binder is prepared as the binger. The average grain diameters of ZrB₂ powder, SiC powder, and B₄C powder, that is to say, median values (d=50) of the particle size distributions measured by a laser diffraction/scattering method have any appropriate average grain diameters: for example, ZrB₂ powder having an average grain diameter of 0.5 µm or more and 3 µm or less, SiC powder having an average grain diameter of 0.3 µm or more and 2 µm or less, and B₄C powder having an average grain diameter of 0.2 µm or more and 4.0 µm or less are prepared.

Subsequently, the prepared ZrB₂ powder, SiC powder, and B₄C powder are mechanically mixed to obtain a powder mixture. In this case, it suffices that the mixing ratio of ZrB₂, SiC, and B₄C is set such that, for example, mass ratios in the conductive ceramic are 69 mass% or more and 94 mass% or less, 5 mass% or more and 30 mass% or less, and 1 mass%, respectively.

Subsequently, the obtained mixture is molded (step (S30)). Specifically, the obtained mixture is poured into a pressure kneader, followed by addition of an organic binder. A resultant material is then subjected to heat and pressure kneading, thereby producing a kneaded material. For example, in consideration of the fluidity of the kneaded material, heat and pressure kneading is performed while rotating the pressure kneader on the conditions that the heating temperature is 100°C or higher and 200°C or lower and the pressure is 0.35 MPa or higher and 0.45 MPa or lower. In this case, the mixing ratio of the organic binder may be, for example, 20 parts by mass to the powder mixture. Subsequently, the kneaded material is subjected to injection molding with a desired die, thereby producing a compact. In this case, the shape of the compact can be appropriately selected in accordance with the shape of the thermocouple. With reference to Fig. 1, it suffices that for example, body 1A with one end closed and the other end opened, extension 1B with the opposite ends opened, and connecting portion 1C connecting body 1A and extension 1B to each other are produced.

Subsequently, the obtained compact is degreased (step (S40)). Specifically, the compact is introduced into the air degrease furnace, and the temperature of the compact is gradually increased from room temperature to about 400°C at temperature increase rate of 20°C/hour, and the compact is heated, thereby producing a degreased material. In this case, the organic binder is mostly subjected to oxidative decomposition.

Subsequently, the degreased material is introduced into the graphite furnace to be calcined (step (S50)). For example, the degreased material is sintered on the heating condition of 2000°C or higher and 2300°C or lower in Ar atmosphere. Consequently, the first conductive ceramic molded as body 1A, extension 1B, and connecting portion 1C can be obtained.

A method of producing a second conductive ceramic will now be described. The method of producing a second conductive ceramic includes the step (S11) of preparing B₄C powder and a binder, the step (S21) of adding the binder to B₄C power and kneading a resultant material while heating, the step (S31) of molding a kneaded material obtained in the kneading step (S21), the step (S41) of degreasing the compact obtained in the molding step (S31), and the step (S51) of calcining a degreased material obtained in the degreasing step (S41).

First, powdered B₄C and an organic binder as a binder are prepared (step ((S11)). Although it suffices that the average grain diameter of B₄C powder, that is, the median value (d=50) of the particle size distribution measured by the laser diffraction/scattering method has any appropriate average grain diameter, for example, B₄C powder having an average grain diameter of 0.2 µm or more and 4.0 µm or less is prepared. The organic binder mainly contains thermoplastic.

Subsequently, the prepared B₄C powder is introduced into a pressure kneader, followed by addition of an organic binder. A resultant material is then subjected to heat and pressure kneading, thereby producing a kneaded material (molding compound having good uniform dispersiveness) (step (S21)). For example, in consideration of the fluidity of the kneaded material, heat and pressure kneading is performed for 90 minutes while rotating the pressure kneader on the conditions that the heating temperature is 100°C or higher and 200°C or lower and the pressure is 0.35 MPa or higher and 0.45 MPa or lower. It suffices that in this case, the volume ratio between B₄C powder and organic binder is, for example, 1:1.

The kneaded material is self-cooled at room temperature, and is then crushed into small pieces serving as a molding material by a crusher. The size of the small pieces is, for example, 4 mm or more and 8 mm or less.

Subsequently, the molding material is subjected to extrusion molding, thereby producing a compact (step (S31)). Specifically, the small pieces obtained by crushing a kneaded material are introduced into the hopper of the extruder, and are subjected to extrusion molding at a cylinder temperature of 140°C or higher and 180°C or lower. In this case, in order to prevent deformation of the compact extruded from the mouthpiece of the extruder, preferably, an elongated metal plate (backing plate) having a V-shaped groove is prepared, and the mouthpiece of the extruder and the groove in the backing plate are disposed to be continuous with each other. Consequently, the compact extruded from the extruder can be received in the groove and can be molded while moving the backing plate in accordance with the discharge rate and discharge direction of the compact, thereby yielding a linear compact that is not bent. Subsequently, the obtained compact is cut in a predetermined length as second conductive member 2.

Subsequently, the obtained compact is degreased (step (S41)). Specifically, the compact is introduced into the air degrease furnace, and the temperature of the compact is gradually increased from room temperature to about 400°C at a temperature increase rate of 20°C/hour. The compact is subsequently heated for five days, thereby producing a degreased material. In the degreased material, the organic binder contained in the compact has been subjected to oxidative decomposition to be removed completely.

Subsequently, the degreased material is introduced into the graphite furnace, followed by calcination (step (S51)). For example, the degreased material is calcined on the heating condition of 2000°C or higher and 2300°C or lower in Ar atmosphere. Consequently, a second conductive ceramic molded as a linear body can be obtained. The linear body with one end processed as a male screw is molded into second conductive member 2.

A method of manufacturing thermocouple 10 will now be described. First, body 1A, extension 1B, and connecting portion 1C obtained in the method of producing a first conductive ceramic described above are assembled to form first conductive member 1.

Subsequently, second conductive member 2 obtained in the method of producing a second conductive ceramic described above is caused to pass through first conductive member 1, and end 2a is screwed to groove 3 of closed end 1a, thereby fixing first conductive member 1 and second conductive member 2 to each other and forming a temperature sensing junction. Subsequently, insulating member 4 is charged into first conductive member 1. Lastly, plug 9 is attached to the open end side of first conductive member 1 to fix first conductive member 1, second conductive member 2, and insulating member 4 to one another, thereby forming thermocouple 10.

The function and effect of thermocouple 10 according to the present embodiment will now be described. The present inventors have studied various conductive ceramics as the first conductive ceramic contained in first conductive member 1 of thermocouple 10, and then found that ZrB₂ and TiB₂ are preferable as main constituent materials of first conductive member 1.

A material having high melting point and a high electric conductivity is suitable for the material for thermocouple. It is known that ZrB₂ and TiB₂ are materials that are good electrical conductors, which are inexpensive and have a high melting point of 1500°C or higher. The melting points of ZrB₂ and TiB₂ are 3246°C and 2900°C, respectively, which are higher than the temperature of a normal molten metal. Further, the electric conductivities of ZrB₂ and TiB₂ are 10⁷ S/m or more, which is equal to that of carbon steel.

The present inventors have evaluated the resistance to thermal shock of a sintered body made of ZrB₂ or TiB₂, and then confirmed that thermal shock causes spalling such as cracking or peeling. Specifically, the conductive ceramic containing ZrB₂, in addition to a sintering agent and unavoidable impurities, is immersed in molten iron of 1600°C without preheating, causing spalling due to thermal shock. The same applies to the conductive ceramic containing TiB₂, in addition to a sintering agent and unavoidable impurities.

In contrast, the present inventors have found through extensive study that the conductive ceramic (first conductive ceramic) mainly containing ZrB₂ or TiB₂ and having a SiC content of 5 mass% or more and 30 mass% or less has a dramatically improved resistance to thermal shock. In actuality, the thermal shock test described above was performed on the first conductive ceramic, and as a result, no spalling occurred. Meanwhile, it was confirmed that a molten steel immersing test was performed on the conductive ceramic having a SiC content outside the above range, and as a result, spalling or melting damage occurred.

Further, the present inventors have confirmed that the electric conductivity of the first conductive ceramic mainly containing ZrB₂ or TiB₂ and having a SiC content of 5 mass% or more and 40 mass% or less is 10⁶ S/m or more and the first conductive ceramic has a sufficiently high electric conductivity as the material for a thermocouple.

As described above, the first conductive ceramic contains any one of ZrB₂ and TiB₂ as its main component, and accordingly has a high melting point and a high electric conductivity. The first conductive ceramic can be produced at low cost compared with a conventional material for thermocouple. Further, the first conductive ceramic contains SiC of 5 mass% or more and 30 mass% or less, and thus can exhibit, as first conductive member 1 in thermocouple 10, a sufficient resistance to melting damage and a sufficient resistance to thermal shock even in the temperature range of molten metal.

Further, the theoretical density ratio of the first conductive ceramic is 90% or more, and the inside of the first conductive ceramic is densified. In this case, the carrier density of the first conductive ceramic uniquely depends on a composition ratio of components (blending ratio of ZrB₂/SiC), so that the accuracy with which thermoelectromotive force is measured can be kept high. Thus, the first conductive ceramic has a composition ratio of components selected appropriately, and accordingly, can stably have a predetermined thermoelectromotive force at a predetermined temperature. As a result, thermocouple 10 according to the present embodiment which contains the first conductive ceramic can keep high measurement accuracy. In contrast, at a low theoretical density ratio of the conductive ceramic, the internal resistance thereof increases (carrier density decreases) to destabilize the thermoelectromotive force, increasing a thermoelectromotive force measurement error. It is therefore difficult to obtain a conductive ceramic having a predetermined thermoelectromotive force, and a thermocouple including the conductive ceramic cannot keep measurement accuracy high.

Further, the present inventors have studied various conductive ceramics as the second conductive ceramic contained in second conductive member 2 of thermocouple 10, and as a result, found that B₄C is suitable as the second conductive ceramic. In other words, the present inventors have found through extensive study that thermocouple 10 including first conductive member 1 made of the first conductive ceramic and second conductive member 2 made of a conductive ceramic (second conductive ceramic) mainly containing B₄C generates an extremely high thermoelectromotive force even in a high temperature environment compared with a conventionally used industrial thermocouple.

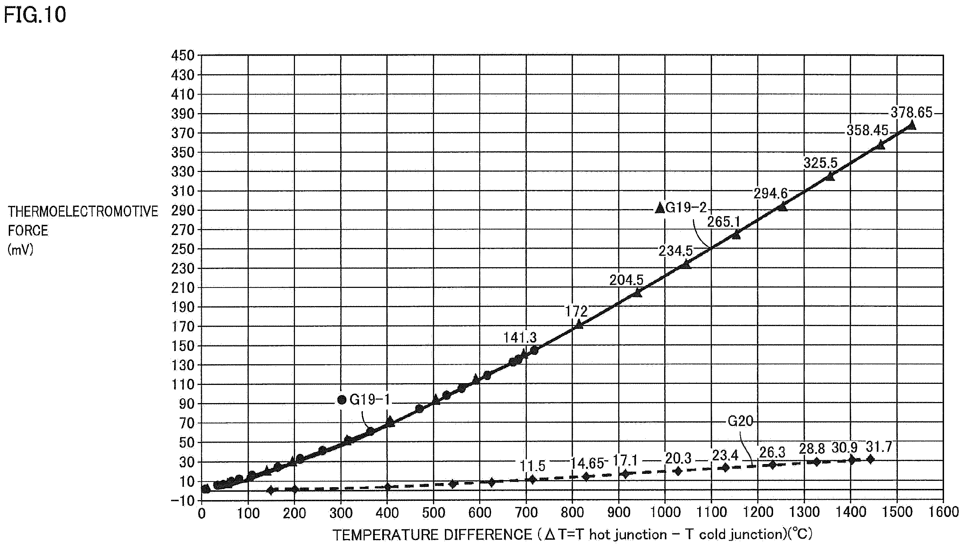

In actuality, the temperature sensing junction of thermocouple 10 according to Example 1 is disposed in the examination furnace heated to a temperature of 1600°C together with a type B thermocouple serving as a standard thermocouple, and then thermoelectromotive forces were measured. As a result, the thermoelectromotive force of the type B thermocouple was 20 mV or less, whereas the thermoelectromotive force of thermocouple 10 was 380 mV (see Fig. 10, detailed description will be given below). That is to say, it was confirmed that thermocouple 10 can generate a thermoelectromotive force 20 times as high as that of a conventionally used industrial thermocouple. The present inventors have found that thermocouple 10 generates a high thermoelectromotive force compared with a thermocouple formed of a first conductive member made of the first conductive ceramic and a second conductive member made of molybdenum (Mo), not the second ceramic.

A common sheathed thermocouple has the following problems: a measured temperature value is lower than an actual temperature of molten metal because the thermocouple needs to be protected by being surrounded by a thick refractory, and prediction control for temperature changes needs to be performed by software because the variations in measured temperature value do not sufficiently follow the temperature changes.

In contrast, first conductive member 1 made of the first conductive ceramic has high durability against molten metal and high durability against a high-temperature reducing atmosphere (e.g., carbon monoxide gas atmosphere) compared with a metal sheath of a conventional sheathed thermocouple. Further, B₄C of the second conductive ceramic has a melting point of 2450°C, which is high as in ZrB₂ and TiB₂. Thermocouple 10 thus does not need to be protected by being surrounded by a thick refractory, unlike a sheathed thermocouple. As a result, the temperature sensing junction of thermocouple 10 can be disposed close to the molten metal of the temperature sensing object compared with the temperature sensing junction of the sheathed thermocouple. Thermocouple 10 can thus perform temperature measurement with high accuracy compared with the sheathed thermocouple.

Since thermocouple 10 mainly contains the first conductive ceramic and the second conductive ceramic, thermocouple 10 can be manufactured at low cost. Further, since thermocouple 10 has a durable time much longer than that of a conventional thermocouple, the use of thermocouple 10 can also reduce a measurement cost.

The content of B₄C in the second conductive ceramic is 50 mass% or more and may be 70 mass% or more. The second conductive ceramic may contain B₄C and unavoidable impurities. As the content of B₄C in the second conductive ceramic is higher, the thermoelectromotive force of thermocouple 10 including second conductive member 2 containing the second conductive ceramic can be increased.

The thermoelectromotive force of thermocouple 10 decreases with the progress of the diffusion of B atoms between the first conductive ceramic and the second conductive ceramic as described above. In order to simultaneously satisfy a period of time when the temperature of an object (e.g., furnace lifetime) needs to be continuously measured and a maximum temperature measurement error allowable in such a case, thus, it suffices that the B concentration in the second conductive ceramic is appropriately selected in accordance with a mode of use of thermocouple 10.

As described above, thermocouple 10 does not need to be protected by being surrounded by a refractory, and the temperature sensing junction of thermocouple 10 is disposed close to the molten metal that is the temperature sensing object compared with the temperature sensing junction of the sheathed thermocouple, and accordingly, thermocouple 10 responds quickly to temperature changes of the molten metal (a measured temperature value can follow quickly) compared with the sheathed thermocouple. This eliminates the need for prediction control by software to cover a response delay, which is performed in the sheathed thermocouple. Consequently, the use of thermocouple 10 enables more fine temperature control of molten metal.

### [Embodiment 2]

A conductive ceramic for thermocouple and a thermocouple 20 according to Embodiment 2 will now be described. With reference to Fig. 3, the conductive ceramic for thermocouple and thermocouple 20 according to Embodiment 2 basically have similar configurations as those of the conductive ceramic for thermocouple and thermocouple 10 according to Example 1 but differ therefrom in that a protective film 8 is formed on the surface of first conductive member 1.

Protective film 8 is made of any appropriate material as long as thermocouple 20 does not wear through reaction with a material to be measured (e.g., molten metal), and is made of, for example, zircon (ZrSiO₄). The thickness of protective film 8 is, for example, 10 µm or more and 250 µm or less, and is preferably 50 µm or more and 150 µm or less.

The method of manufacturing a conductive ceramic for thermocouple further includes the step of forming protective film 8 on the outer peripheral surface of first conductive member 1, subsequent to the calcining step (S50). Although any appropriate method is adoptable in the step of forming protective film 8, for example, it suffices that first conductive member 1 made of the conductive ceramic for thermocouple which contains ZrB₂ is heated to 1450°C or higher and 1600°C or lower in air. Consequently, protective film 8 made of ZrSiO₄ is formed on the surface of first conductive member 1. The thickness of protective film 8 formed by the above process is, for example, 10 µm or more and 80 µm or less.

It suffices that protective film 8 is formed at least on the outer peripheral surface (a surface that comes into direct contact with a material to be measured) of first conductive member 1.

The effect and operation of the conductive ceramic for thermocouple and thermocouple 20 according to Embodiment 2 will now be described. When thermocouple 20 is used to measure the temperature of molten metal, first conductive member 1 forming the outermost surface of thermocouple 20 is placed in a high oxygen atmosphere. Specifically, the molten metal contains oxygen, and normally, the oxygen content varies greatly within the range of several parts per million or more and several hundreds of parts per million or less. Thus, thermocouple 20 immersed in the molten metal is placed in a high oxygen atmosphere. When thermocouple 20 is attached to, for example, a ladle in the steel making process, thermocouple 20 is placed in air atmosphere if it has not been immersed in the molten metal. The present inventors have confirmed that the conductive ceramic for thermocouple placed in such an atmosphere gradually wears through oxidation of ZrB₂ or TiB₂.

It is known that when ZrB₂ having a SiC content of 5 mass% is heated to a high temperature, a coating of silicon oxide (SiO₂) is formed on the surface, which reduces the progress of oxidation in air (F. Peng et al, J. Am. Ceram. Soc, 91[5] 1489-1494 (2008)). However, the present inventors have confirmed that when a SiO₂ coating is immersed in molten metal, it combines with another oxide in the molten metal to form a low-melting-point oxide, and peels off easily. That is to say, the SiO₂ film does not function as an oxidation-resistance film of the first conductive member in a thermocouple for measuring the temperature of molten metal.

The present inventors have confirmed that by the formation of a coating (protective film 8) of ZrSiO₄ on the surface of first conductive member 1 made of first conductive ceramic, the coating does not dissolve easily even when being immersed in molten metal, reducing wear of conductive ceramic for thermocouple due to oxidation.

Since ZrSiO₄ has insulating properties, the first conductive member made of conductive ceramic for thermocouple and its surroundings (such as molten metal) can be electrically insulated from each other. As a result, protective film 8 can cut off electrical noise from its surroundings, allowing thermocouple 20 to perform temperature measurement with high accuracy.

Protective film 8 can be formed by a method of thermally spraying ZrSiO₄ onto the surface of the conductive ceramic for thermocouple, in addition to the method of subjecting the conductive ceramic for thermocouple to heating oxidation.

The material for protective film 8 is not limited to ZrSiO₄ and may be ZrO₂. It is conceivable that effects similar to those of ZrSiO₄ can be achieved even by the above method.

Although the first conductive ceramic according to Embodiment 1 and Embodiment 2 is formed by injection molding, the present invention is not limited thereto. Although the second conductive ceramic is formed by extrusion molding, the present invention is not limited thereto. The first conductive ceramic and the second conductive ceramic each may be formed by, for example, any one of injection molding, pressure sintering (hot pressing), and extrusion molding.

Thermocouples 10 and 20 according to Embodiment 1 and Embodiment 2 are suitable for, for example, the following use.

First, thermocouples 10 and 20 have high durability against molten metal, and are accordingly suitable for thermocouples that can continuously measure the temperature of molten metal.

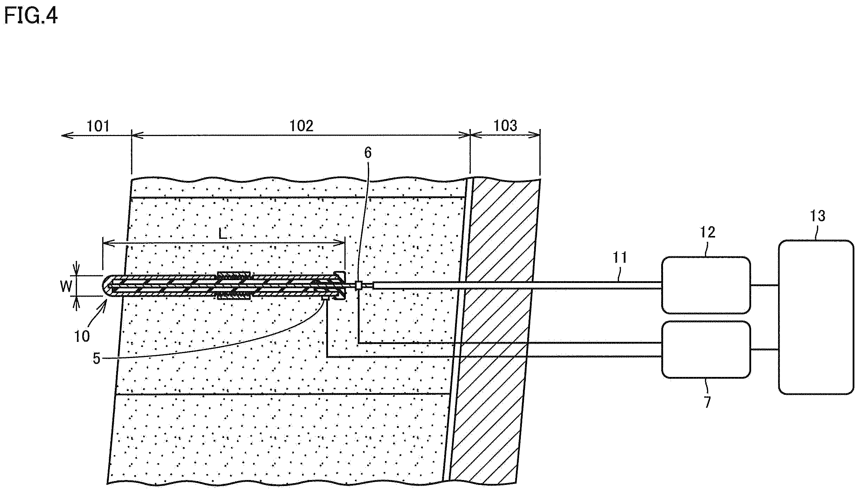

Fig. 4 shows thermocouple 10 configured as a thermocouple buried in a converter wall for continuously measuring the temperature of molten steel. The converter is externally covered with a shell 103 formed of a steel plate and is internally lined with a refractory 102, and includes a furnace interior 101 which is surrounded by refractory 102 and into which molten steel is poured. In thermocouple 10, a temperature sensing junction is provided in furnace interior 101, and a reference junction is provided in refractory 102. That is to say, both of closed end 1a of first conductive member 1 and end 2a of second conductive member 2 of thermocouple 10 are provided to be located in furnace interior 101. Also, electrode pad 6 connected to second conductive member 2 is provided to be located in refractory 102. Further, a thermocouple 11 (e.g., sheathed thermocouple) is provided that has one end (temperature sensing junction) disposed near electrode pad 6 and extends to the outside of the converter through refractory 102 and shell 103. Thermocouple 11 is connected to a reading thermometer provided to the exterior of the converter and is provided to measure the temperature of the vicinity of electrode pad 6 (i.g., reference junction).

Further, electrode pad 5 connected to first conductive member 1 is provided to be located in refractory 102. Electrode pad 5 and electrode pad 6 are each connected to a voltmeter 12 (mV meter) provided to the exterior of the converter, and voltmeter 12 is provided to measure the thermoelectromotive force of thermocouple 10.

As a result, for example, when the temperature of the reference junction which is measured by thermocouple 11 is 800°C and the thermoelectromotive force measured by voltmeter 12 is 220 mV, the temperature of molten steel can be calculated to be 1575°C from the graph showing the relationship between the thermoelectromotive force of thermocouple 10 and the temperature difference shown in Fig. 10 described below.

The converter including thermocouple 10 configured as described above does not need to have a through-hole formed for allowing thermocouple 10 to pass through shell 103.

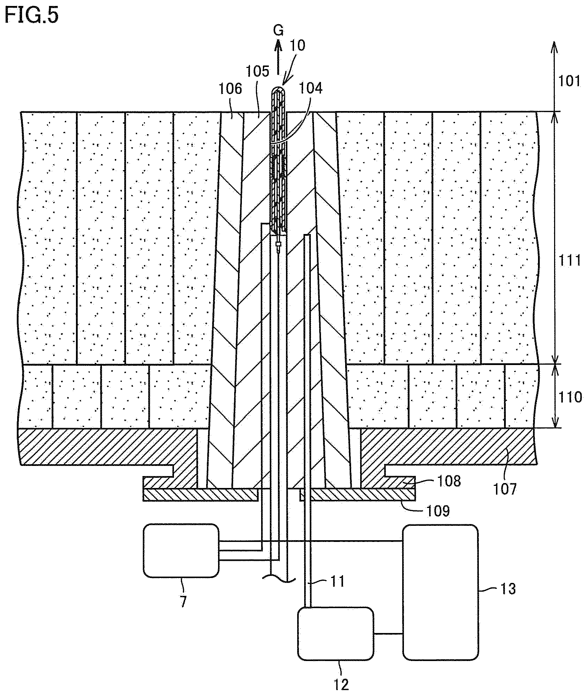

Fig. 5 shows thermocouple 10 configured as a thermocouple buried in the bottom of the converter for continuously measuring the temperature of molten steel.

The bottom of the converter is formed of, for example, a shell 107, a permanent brick 110 lined in shell 107, and a refractory 111 lined inside of permanent brick 110 and serving as a consumable material. A flange 108 is formed in shell 107.

A bottom-blown tuyere 104 is provided to pass through permanent brick 110 and refractory 111. Bottom-blown tuyere 104 includes a tuyere brick 105 and a tuyere surrounding brick 106 surrounding tuyere brick 105 and inserted into a through-hole formed in refractory 111 and permanent brick 110. Bottom-blown tuyere 104 is held by a holding lid 109 fixed to flange 108 in the opening of flange 108 formed in shell 107.

Thermocouple 10 is provided with its temperature sensing junction provided in furnace interior 101 and its reference junction provided in bottom-blown tuyere 104 provided in the furnace bottom. Electrode pads 5 and 6 and thermocouple 11 for measuring the temperature of the reference junction of thermocouple 10 are further disposed in bottom-blown tuyere 104. In bottom-blown tuyere 104, for example, gas for stirring or gas for smelting flows to furnace interior 101, and bottom-blown tuyere 104 is provided such that a mixed gas thereof functions as a gas for cooling the reference junction.

Alternatively, thermocouple 10 may be configured as a thermocouple buried in the bottom of an electric furnace for continuously measuring the temperature of molten steel.

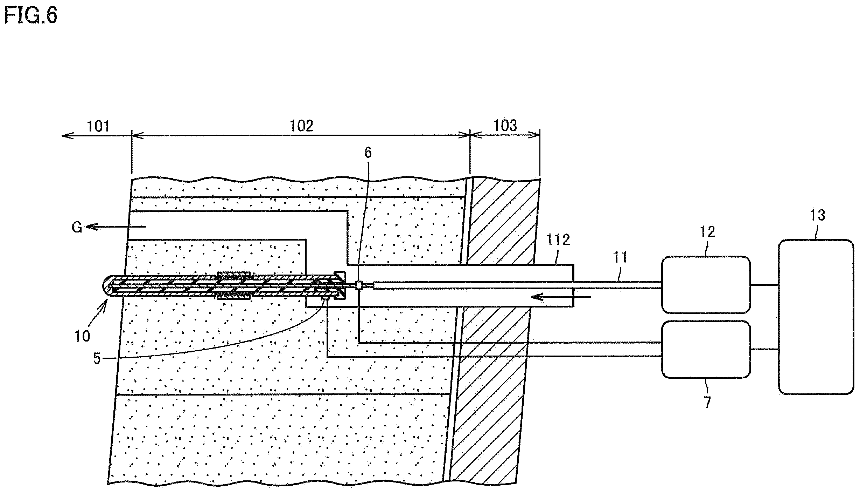

Fig. 6 shows thermocouple 10 configured as a thermocouple buried in a side wall of an argon oxygen decarburization (AOD) furnace for continuously measuring the temperature of molten steel. Thermocouple 10 has a temperature sensing junction provided in furnace interior 101 and a reference junction provided in a side-blown tuyere 112 provided in a side wall of the AOD furnace. Further, electrode pads 5 and 6 and thermocouple 11 for measuring the temperature of the reference junction of thermocouple 10 are disposed in side-blown tuyere 112. In side-blown tuyere 112, for example, oxygen-argon mixed gas flows from the outside of the AOD furnace to furnace interior 101, and blown tuyere 112 is provided such that this mixed gas functions as the gas for cooling the reference junction.

Further, thermocouples 10 and 20 have high durability against a reducing atmosphere in a high temperature environment, and is accordingly suitable for a thermocouple for measuring the temperature in the reducing atmosphere.

For example, the furnace interior of a blast furnace is in a CO gas atmosphere, and the wall of the blast furnace is formed of a graphite brick such as a carbon brick as a refractory, and thus, it can be said that the blast furnace is in a reducing atmosphere. Thermocouple 10 is provided such that the temperature sensing junction is located in the furnace interior and the reference junction is located inside the graphite brick, and accordingly, thermocouple 10 is suitable as a thermocouple for continuously measuring the reducing atmosphere temperature of the furnace interior. Further, thermocouple 10 is provided such that the temperature sensing junction is located immediately outside the taphole and the reference junction is located inside the graphite brick serving as a refractory surrounding the taphole, and accordingly, is also suitable as a thermocouple for continuously measuring the temperature at the taphole. The management of the temperature of the taphole of the blast furnace is an important factor that serves as an index of determination of a reaction inside the blast furnace, management of a charge, and control of ventilation, and accurate measurement of the temperature of the taphole of the blast furnace needs temperature measurement continuously performed immediately outside the taphole. However, the temperature of the molten iron dramatically decreases after the molten iron exits the taphole, and a commonly measured temperature at an iron runner has been considerably lower than the temperature of the taphole, and also, the value thereof easily varies due to disturbance factors. Thus, temperature measurement is preferably performed continuously immediately outside the taphole in order to use the temperature of the taphole in feedback to an operation of the blast furnace. Thermocouple 10 has high durability against reducing molten iron, and accordingly, is suitable for the above use from the above reason.

The furnace interior of a coke oven is filled with coke and CO gas and is in a reducing atmosphere. Thermocouple 10 is accordingly suitable for such a use from the above reason.

Further, thermocouples 10 and 20 need not to be protected by being surrounded by a thick refractory, unlike a conventional sheathed thermocouple. Thus, thermocouples 10 and 20 can measure the actual temperature of molten steel metal with high accuracy, and has high response to temperature changes. Thermocouples 10 and 20 are accordingly suitable also for measuring the temperature of a high-temperature portion that requires highly accurate temperature control.

For example, in order to improve the mechanical characteristics of a steel sheet, the temperature of the steel sheet is required to be managed in rolling, and a fine heat treatment after rolling is required (e.g., quick heating or cooling of a steel sheet). In order to provide such a temperature pattern in a heat treatment as designed, the temperature of an object (steel sheet) needs to be measured continuously, and the cooling conditions (e.g., an amount of cooling water) and the heating conditions (e.g., a heating temperature by a heater) need to be controlled based on the measurement results. Thus, thermocouples 10 and 20 having good response are also suitable for such a use.

### Example 1

Examples of the thermocouple according to Embodiment 1 will now be described. In the present examples, first conductive member 1 was evaluated in terms of the thermoelectromotive force of the thermocouple.

### <Samples >

### [Sample 1]

A first conductive member 1 was produced in accordance with the method of producing a first conductive ceramic according to Embodiment 1. Specifically, first, SiC powder having an average grain diameter of 0.7 µm, ZrB₂ powder having an average grain diameter of 2.1 µm, and B₄C powder having an average grain diameter of 0.4 µm and serving as a sintering agent were prepared. SiC powder, ZrB₂ powder, and B₄C powder were mechanically mixed at a ratio of 5 mass%, 94 mass%, and 1 mass%, respectively. 20 parts of organic binder were added to the obtained mixture, followed by heat and pressure kneading by a pressure kneader to produce a uniformly dispersed compound (kneaded material). Subsequently, the compound was pelletized into a molding material. This molding material was introduced into an injection machine, and a plasticized molding material was ejected into a mold cavity having a length of 62 mm, a width of 19 mm, and a thickness of 4.5 mm at a pressure of 50 to 100 MPa. The dimensions of the mold can be selected in accordance with the outside dimensions of a thermocouple, given that for example, an assumed shrinkage percentage of a calcined product to the compact is about 16%. The molding material was cooled and solidified in the mold and is then taken out of the mold to produce a compact. This compact was introduced into a degrease furnace to decompose the organic binder contained in the compact by heating. The obtained degreased material was subjected to heat sintering at 2250°C in Ar atmosphere using the graphite furnace to produce a sintered body (conductive ceramic for thermocouple). Subsequently, the obtained sintered body was ground into a desired shape by a surface grinding machine, thereby forming a first conductive member.

A metal material made of Mo was prepared as a second conductive member and an end of the metal material was fixed to a closed end of the first conductive member. The first conductive member and the second conductive member were insulated from each other by ZrO₂. An electrode was attached to each of the first conductive member and the second conductive member to obtain a thermocouple of sample 1.

### [Sample 2]

A second thermocouple of sample 2 was obtained by providing a configuration similar to that of sample 1 except for setting the ratios of SiC powder, ZrB₂ powder, and B₄C powder in the above mixture to 30 mass%, 69 mass%, and 1 mass%, respectively.

### [Sample 3]

A thermocouple of sample 3 was obtained by providing a configuration similar to that of sample 1 except for setting the ratios of SiC powder, ZrB₂ powder, and B₄C powder in the above mixture to 40 mass%, 59 mass%, and 1 mass%, respectively.

### [Sample 4]

A first conductive member was obtained by setting the ratios of SiC powder, ZrB₂ powder, and B₄C powder in the above mixture to 5 mass%, 94 mass%, and 1 mass%, respectively.

Further, a second conductive member was formed by setting the ratios of SiC powder, ZrB₂ powder, and B₄C powder in the above mixture to 40 mass%, 59 mass%, and 1 mass%, respectively, and an end of the second conductive material was fixed to a closed end of the first conductive member. The first conductive member and the second conductive member were insulated from each other by ZrO₂. An electrode was attached to each of the first conductive member and the second conductive member to obtain a thermocouple of sample 4. That is to say, a thermocouple of sample 4 was obtained by providing a configuration similar to that of sample 1 except for using, as the second conductive member, a conductive ceramic for thermocouple which has a silicon carbide content different from that of the first conductive member.

### [Sample 5]

A thermocouple of sample 5 was obtained by providing a configuration similar to that of sample 1 except for using a metal material made of W as the second conductive member.

### <Evaluations>

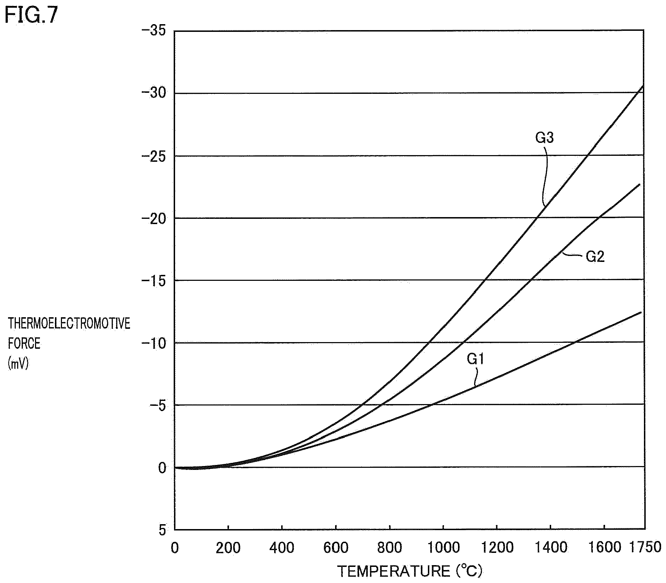

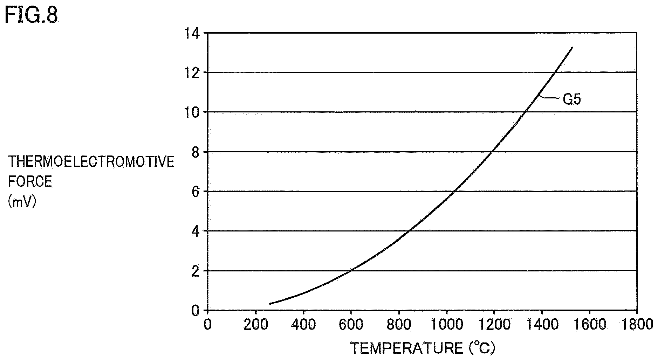

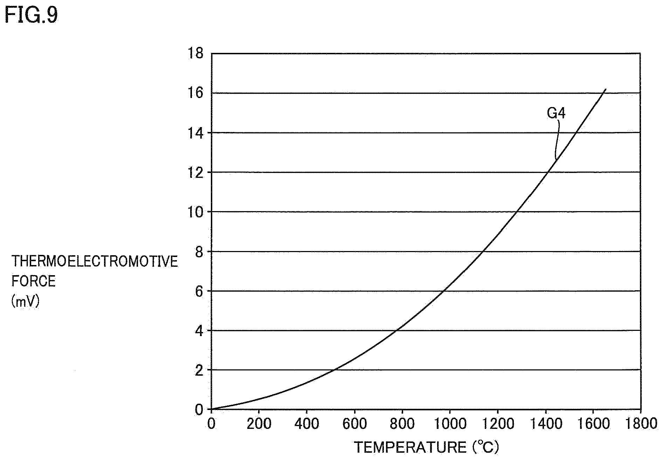

A temperature difference was caused between the temperature sensing junction provided at one end of each thermocouple of sample 1, sample 2, sample 3, sample 4, and sample 5 and the other end, and a thermoelectromotive force was measured. Figs. 7, 8, and 9 show the measurement results. In Figs. 7 and 8, the horizontal axis and vertical axis of represent a temperature difference (unit: °C) and a thermoelectromotive force (unit: mV), respectively. Fig. 7 shows the result of sample 1 as G1, the result of sample 2 as G2, and the result of sample 3 as G3. Fig. 8 shows the result of sample 5 as G5. Fig. 9 shows the result of sample 4 as G4.

With reference to Fig. 7, it was confirmed that all of sample 1, sample 2, and sample 3 have a thermoelectromotive force sufficient as a thermocouple and that the temperature thereof can be measured stably also in a high temperature range. It was also confirmed that a first conductive ceramic having a higher SiC content has a higher thermoelectromotive force in configuring a thermocouple. In particular, sample 2 and sample 3 exhibited thermoelectromotive forces higher than a thermoelectromotive force of sample 1, and a difference in thermoelectromotive force between sample 2 and sample 1 and a difference in thermoelectromotive force between sample 3 and sample 1 were particularly conspicuous in a high temperature range of 1000 °C or higher. It was confirmed that the thermocouple of sample 1 has a thermoelectromotive force nearly equal to that of the type S thermocouple in the JIS standard. It was confirmed that the thermocouple of sample 2 has a thermoelectromotive force nearly equal to that of the type B thermocouple in the JIS standard.

With reference to Fig. 8, it was confirmed that sample 5 has a thermoelectromotive force sufficient as a thermocouple and the temperature of sample 5 can be stably measured also in a high temperature range, similarly to sample 1, sample 2, and sample 3. The thermoelectromotive force of sample 5 is higher than the thermoelectromotive force of sample 1 in which the first conductive member is made of the first conductive ceramic having a SiC content equal to that of the first conductive member of sample 5 and the second conductive member is made of Mo. It was also confirmed that the thermoelectromotive force of sample 5 tends to be smaller than that of sample 2 in which the first conductive member is made of the first conductive ceramic having a SiC content higher than that of the first conductive member of sample 5 and the second conductive member is made of Mo.

With reference to Fig. 9, it was confirmed that sample 4 has a thermoelectromotive force sufficient as a thermocouple and the temperature of sample 4 can be measured stably also in a high temperature range, similarly to sample 1, sample 2, sample 3, and sample 5. It was confirmed that the thermoelectromotive force of sample 4 is equal to a difference between the thermoelectromotive force of sample 1 in which the first conductive member is made of the first conductive ceramic having a SiC content of 5% and the thermoelectromotive force of sample 3 in which the first conductive member is made of the first conductive ceramic having a SiC content of 40%. It was confirmed that the thermocouple of sample 4 has a thermoelectromotive force nearly equal to that of the type R thermocouple in the JIS standard.

### Example 2

Next, the first conductive ceramic according to Embodiment 1 was evaluated in terms of a resistance to thermal shock and a resistance to melting damage in Example 2. Specifically, in this example, conductive ceramics for thermocouple having different SiC contents were immersed in molten steel, and the resistance to thermal shock and the resistance to melting damage thereof were evaluated.

### <Samples >

### [Sample 6 to Sample 13]

The conductive ceramics for thermocouple of sample 6 to sample 13 were obtained by using ZrB₂ as a main component and changing a SiC content in the range of 0 mass% or more and 40 mass% or less in accordance with the method of producing a first conductive ceramic according to Embodiment 1. Specifically, the SiC contents of sample 6, sample 7, sample 8, sample 9, sample 10, sample 11, sample 12, and sample 13 were set to 40 mass%, 30 mass%, 20 mass%, 12 mass%, 5 mass%, 2 mass%, 1 mass%, and 0 mass%, respectively. The content of B₄C serving as a sintering agent was 1 mass% in each sample. In other words, the ZrB₂ contents of sample 6, sample 7, sample 8, sample 9, sample 10, sample 11, sample 12, and sample 13 were set to 59 mass%, 69 mass%, 79 mass%, 87 mass%, 94 mass%, 97 mass%, 98 mass%, and 99 mass%, respectively. The outside dimensions of each sample were 2 mm × 2 mm × 30 mm. A specific method of producing each sample was performed as in the case of sample 1 of Example 1 described above.

### [Sample 14 to Sample 18]

The first conductive ceramics of sample 14 to sample 18 were obtained by using TiB₂ as a main component and changing a SiC content in the range of 0 mass% or more and 40 mass% or less in accordance with the method of producing a first conductive ceramic according to Embodiment 1. Specifically, the SiC contents of sample 14, sample 15, sample 16, sample 17, and sample 18 were set to 30 mass%, 20 mass%, 12 mass%, 5 mass%, and 0 mass%, respectively. The content of B₄C serving as a sintering agent was 1 mass% in each sample. That is to say, the TiB₂ contents of sample 14, sample 15, sample 16, sample 17, and sample 18 were set to 69 mass%, 79 mass%, 87 mass%, 94 mass%, and 99 mass%, respectively. The outside dimensions of each sample were 2 mm × 2 mm × 30 mm. A specific method of producing each sample was performed as in the case of sample 1 of Example 1 described above.

### <Evaluations>

A heating furnace having a resistance of 1 kg was heated to 1630°C to form molten steel, and the first conductive ceramics of samples 6 to 18 were immersed in the molten steel, followed by evaluation of the presence or absence of spalling and melting damage. Two ways of evaluations were performed independently when each sample was preheated and then immersed and when each sample was immersed without preheating. Herein, being "preheated and then immersed" means that the sample (about room temperature) left at room temperature was held for about 10 seconds immediately above the molten steel and then immersed in the molten steel. Being "immersed without preheating" means that the sample (about room temperature) left at room temperature was immediately immersed in the molten steel. The evaluations were made by immersing about 10 mm of the sample in the longitudinal direction in the molten steel and observing the presence or absence of spalling and melting damage in the immersed portion. Table 1 shows evaluation results.

**[Table 1]**

| | Ceramics | SiC mass ratio (mass%) | Preheating | Evaluation Results | |
|---|---|---|---|---|---|
| | | | | Melting damage | Spalling |
| Sample 6 | ZrB₂ | 40 | done | present | - |
| | | | not done | present | - |
| Sample 7 | ZrB₂ | 30 | done | present(minute) | - |
| | | | not done | present(minute) | - |
| Sample 8 | ZrB₂ | 20 | done | absent | absent |
| | | | not done | absent | absent |
| Sample 9 | ZrB₂ | 12 | done | absent | absent |
| | | | not done | absent | absent |
| Sample 10 | ZrB₂ | 5 | done | absent | absent |
| | | | not done | absent | present(minute) |
| Sample 11 | ZrB₂ | 2 | done | absent | present |
| | | | not done | absent | present |
| Sample 12 | ZrB₂ | 1 | done | absent | present |
| | | | not done | absent | present |
| Sample 13 | ZrB₂ | 0 | done | absent | present |
| | | | not done | absent | present |
| Sample 14 | TiB₂ | 30 | done | present(minute) | absent |
| | | | not done | present(minute) | present |
| Sample 15 | TiB₂ | 20 | done | absent | absent |
| | | | not done | absent | present |
| Sample 16 | TiB₂ | 12 | done | absent | absent |
| | | | not done | absent | present |
| Sample 17 | TiB₂ | 5 | done | absent | absent |
| | | | not done | absent | present |
| Sample 18 | TiB₂ | 0 | done | absent | present |
| | | | not done | absent | present |

Spalling did not occur and no melting damage was found in sample 8 and sample 9. In sample 10, spalling or melting damage was not found when the sample was preheated and then immersed. In sample 10, no melting damage was found but minute spalling was found when the sample was immersed without preheating. However, the degree of spalling is such that no problems arises also when the temperature of the continuous temperature measurement was performed as a thermocouple. It was also confirmed in sample 7 that minute melting damage was found, but the sample is sufficiently applicable to a thermocouple for spot temperature measurement for an immersion time within, for example, ten seconds.

In contrast, spalling was found irrespective of whether preheating was performed in sample 11 to sample 13 having a SiC content lower than that of sample 10. As to this point, it is conceivable that ZrB₂ in the first conductive ceramic may wear through oxidation by oxygen in the molten steel.

It was also confirmed that sample 6 having a SiC content higher than that of sample 7 experiences melting damage irrespective of whether preheating was performed. As to this point, it is conceivable that the molten steel may infiltrate into the SiC tissue in the first conductive ceramic, which causes melting damage.

That is to say, it was confirmed that the first conductive ceramic mainly containing ZrB₂ and having a SiC content of 5 mass% or more and 30 mass% or less has a good resistance to thermal shock and a good resistance to melting damage and is suitable for, for example, measuring the temperature of molten steel. It was also confirmed that the first conductive ceramic according to Embodiment 1 which mainly contains ZrB₂ and has a SiC content of 5 mass% or more and 20 mass% or less has a higher resistance to melting damage and a higher resistance to thermal shock and is suitable for, for example, continuously measuring the temperature of molten steel for a long period of time.

It was also confirmed that the first conductive ceramic mainly containing ZrB₂ and having a SiC content of 40 mass% has a practically sufficient thermoelectromotive force as indicated by sample 4 of Example 1 though it has a problem in a resistance to thermal shock and a resistance to melting damage, and accordingly, the first conductive ceramic functions as a first conductive member that does not come into direct contact with molten steel, similarly to sample 4.

Similarly, in sample 15 to sample 17, spalling did not occur and no melting damage was found when they were preheated. On the other hand, in sample 15 to sample 17, no melting damage was found but minute spalling was found when the sample was immersed without preheating.

In sample 14 having a SiC content higher than that of sample 15, spalling did not occur but minute melting damage was found when preheating was performed. On the other hand, in sample 14, minute melting damage was found and minute spalling was found when the sample was immersed without preheating. In sample 18 having a SiC content lower than that of sample 17, spalling was found irrespective of whether preheating was performed. As to this point, it is conceivable that TiB₂ in the first conductive ceramic may wear through oxidation by an oxygen of the molten steel.

That is to say, it was confirmed that the first conductive ceramic mainly containing TiB₂ has a tendency similar to that of the first conductive ceramic mainly containing ZrB₂. Thus, it is conceivable that melting damage may occur irrespective of whether preheating was performed when a SiC content exceeds 30%, and that spalling may occur irrespective of whether preheating was performed when a SiC content is smaller than 5%. Further, it is conceivable that even a mixed ceramic of ZrB₂ and TiB₂ can achieve similar effects by setting its SiC content to 5 mass% or more and 30 mass% or less.

It was confirmed from the above that a conductive ceramic for thermocouple which contains ZrB₂ and/or TiB₂, SiC, a sintering agent, and unavoidable impurities and has a SiC content of 5 mass% or more and 40 mass% or less sufficiently functions as a material for high-temperature thermocouple and is produced at low cost. Further, it was confirmed that the first conductive ceramic containing ZrB₂ and/or TiB₂, SiC, a sintering agent, and unavoidable impurities and having a SiC content of 5 mass% or more and 30 mass% or less is produced at low cost and has a good resistance to thermal shock and a good resistance to melting damage. It was also confirmed that the first conductive ceramic containing ZrB₂ and/or TiB₂, SiC, a sintering agent, and unavoidable impurities and having a SiC content of 5 mass% or more and 20 mass% or less is produced at low cost and has a high resistance to thermal shock and a high resistance to melting damage.

### Example 3

In Example 3, next, thermocouple 10 according to Embodiment 1 was evaluated in terms of the magnitude of thermoelectromotive force and thermal responsiveness.

### <Samples>

### [Sample 19]

A thermocouple 10 was produced in accordance with the method of manufacturing a thermocouple according to Embodiment 1. Specifically, first, SiC powder having an average grain diameter of 0.7 µm, ZrB₂ powder having an average grain diameter of 2.1 µm, and B₄C powder having an average grain diameter of 0.4 µm and serving as a sintering agent were prepared. SiC powder, ZrB₂ powder, and B₄C powder were mechanically mixed at a ratio of 10 mass%, 89 mass%, and 1 mass%, respectively. 20 parts of organic binder were added to the obtained mixture, followed by heat and pressure kneading by a pressure kneader to produce a uniformly dispersed compound (kneaded material). Subsequently, the compound was pelletized into a molding material. This molding material was introduced into an injection machine, and a plasticized molding material was ejected at a pressure of 100 MPa or more and 150 MPa or less into a mold cavity having a cylindrical shape with an outside diameter ϕ of 20 mm, an inside diameter ϕ of 14 mm, and a length of 130 mm and having one end closed. The dimensions of the mold can be selected in accordance with the outside dimensions of a thermocouple, given that for example, an assumed shrinkage percentage of a calcined product to the compact is about 16%. The mold herein is a mold that can form a groove serving as a female screw hole inside the first conductive ceramic. The molding material was cooled and solidified in the mold and then taken out of the mold to produce a compact. This compact was introduced into a degrease furnace, thereby subjecting the organic binder contained in the compact to decomposition by heating. The obtained degreased material was subjected to heat sintering at 2250°C in Ar atmosphere using the graphite furnace to produce a sintered body (first conductive ceramic).

Further, B₄C powder having an average grain diameter of 2.5 µm was prepared, followed by addition of 20 mass parts of organic binder. A resultant material is then subjected to heat and pressure kneading, thereby producing a uniformly dispersed compound (kneaded material). Small pieces obtained by crushing the kneaded material were introduced into the hopper of the extruder and subjected to extrusion molding at a cylinder temperature of 140°C or higher and 160°C or lower. At this time, molding was performed by continuous extrusion with the mouthpiece of the extruder set to a diameter ϕ of 5 mm. In order to prevent deformation of the compact extruded from the mouthpiece of the extruder, an elongated metal plate (backing plate) with a V-shaped groove was prepared and disposed such that the mouthpiece of the extruder and the groove on the backing plate are continuous with each other. Consequently, a linear compact that is not bent was obtained. The obtained compact was cut in a predetermined length as second conductive member 2. This compact was introduced into the degrease furnace, and the organic binder contained in the compact was subjected to decomposition by heating. The obtained degreased material was subjected to heat sintering at 2250°C in Ar atmosphere using the graphite furnace to produce a sintered body (second conductive ceramic). Subsequently, the sintered body was cut in a predetermined length, and the end thereof was subjected to thread cutting, thereby forming a second conductive member with an end serving as a male screw.

The groove of the first conductive member and the end of the second conductive member were screwed to be fixed to each other. The first conductive member and the second conductive member were insulated from each other by ZrO₂. An electrode was attached to each of the first conductive member and the second conductive member to obtain a thermocouple of sample 19.

### [Sample 20]

A thermocouple of sample 20 was obtained by providing a configuration similar to that of sample 1 except for preparing a metal material made of Mo as a second conductive member.

### <Evaluation 1>

A temperature difference was caused between a temperature sensing junction provided at one end of each thermocouple of sample 19 and sample 20 and the other end, and thermoelectromotive forces were measured. Fig. 10 shows the measurement results. The horizontal axis and the vertical axis in Fig. 10 represent a temperature difference (unit: °C) and a thermoelectromotive force (unit: mV), respectively. For sample 19, a first measurement was performed up to a temperature difference of 700°C, and separately, a second measurement was performed up to a temperature difference of 1600°C. Fig. 10 shows the first measurement result of sample 19 as G19-1 (a plot of a black circle in the figure), the second measurement result of sample 19 as G19-2 (a plot of a black triangle in the figure), and the result of sample 20 as G20.

With reference to Fig. 10, it was confirmed that sample 19 has a thermoelectromotive force sufficient as a thermocouple, and the temperature thereof can be measured stably also in a high temperature range. Specifically, sample 19 generated significantly high thermoelectromotive forces: for example, 95 mV at a temperature difference of 500°C, 141 mV at a temperature difference of 700°C, 234.5 mV at a temperature difference of 1050°C, and 380 mV at a temperature difference of 1600°C.

In contrast, sample 20 had a thermoelectromotive force of 31 mV at a temperature difference of 1600°C and had a thermoelectromotive force higher than that of a conventional industrial thermocouple (e.g., type B thermocouple) which exhibits, for example, a thermoelectromotive force of about 20 mV at a temperature difference of 1600°C. It was confirmed that, however, sample 19 can generate a thermoelectromotive force exceeding that of sample 20 and can generate a thermoelectromotive force about 20 times as high as that of a conventional industrial thermocouple. The thermoelectromotive force of sample 19 being about 20 times as high as that of a conventional industrial thermocouple means a higher resolution at which the thermoelectromotive force is converted into the temperature of a temperature sensing object, and also means that the thermocouple of sample 19 can be measured at an accuracy about 20 times as high as that of a conventional thermocouple.

### [Sample 21, Sample 22]

A commercially available type B thermocouple was prepared as sample 21, and a commercially available type K thermocouple was prepared as sample 22.

### <Evaluation 2>

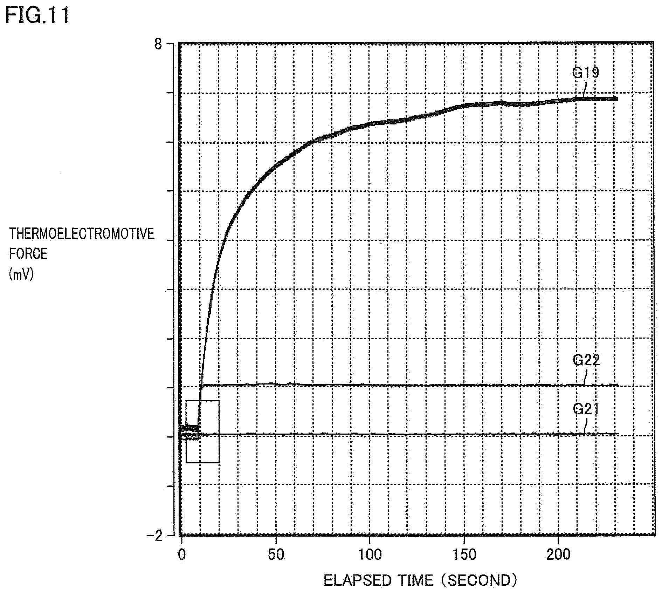

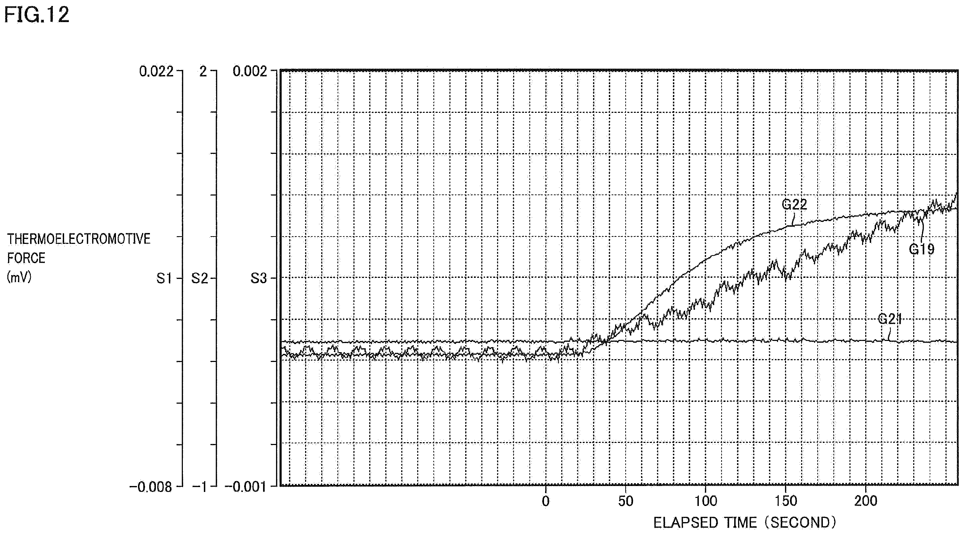

A thermal response was evaluated for each thermocouple of sample 19, sample 21, and sample 22. Specifically, the thermocouples of sample 19, sample 21, and sample 22 were simultaneously immersed in hot water at a temperature of 50°C, and changes in thermoelectromotive force on the same conditions were measured. Figs. 11 and 12 show measurement results. Fig. 12 is a partially enlarged view of Fig. 11. In Figs. 11 and 12, the horizontal axis represents an elapsed time (unit: second) with an instant when the thermocouple was immersed in hot water being zero seconds, and the vertical axis represents a thermoelectromotive force (unit: mV). Figs. 11 and 12 show the result of sample 19 as G19, the result of sample 21 as G21, and the result of sample 22 as G22. Fig. 12 shows a scale of the vertical axis (thermoelectromotive force) of G19 indicated by S1, a scale of the horizontal axis (thermoelectromotive force) of G20 indicated by S2, and a scale of the vertical axis (thermoelectromotive force) of G21 indicated by S3.

As shown in Fig. 11, it was confirmed that the thermocouple of sample 19 can generate a significantly high thermoelectromotive force for a short period of time compared with the thermocouples of sample 21 and sample 22. Further, as shown in Fig. 12, it was confirmed that the thermocouple of sample 19 has a short elapsed time from immersion to measurement of its thermoelectromotive force compared with thermocouples of sample 21 and sample 22. For the type B thermocouple of sample 21, the generation of a thermoelectromotive force was not found. For the type K thermocouple of sample 22, the generation of a thermoelectromotive force was found within 0.5 second from immersion. For the thermocouple of sample 19, however, it was confirmed that a thermoelectromotive force was generated within about 0.2 second from immersion and that the thermoelectromotive force of sample 19 exhibits a better thermal response than that of the type K thermocouple of sample 22.

It should be construed that the embodiments disclosed herein are given by way of illustration in all respects, not by way of limitation. It is therefore intended that the scope of the present invention is defined by claims, not only by the embodiments described above, and encompasses all modifications and variations equivalent in meaning and scope to the claims.

### REFERENCE SIGNS LIST

1 first conductive member, 1A body, 1B extension, 1C connecting portion, 1a closed end, 1b open end, 2 second conductive member, 2a end, 3 groove, 4 insulating member, 5, 6 electrode pad, 8 protective film, 10 thermocouple.

## Claims

1. A thermocouple comprising:
a first conductive member; and
a second conductive member,
the first conductive member and the second conductive member being connected to each other to form a temperature sensing junction,
the first conductive member containing a first conductive ceramic containing zirconium diboride and/or titanium diboride, silicon carbide, a sintering agent, and unavoidable impurities,
a content of the silicon carbide being 5 mass% or more and 40 mass% or less in the first conductive ceramic,
the second conductive member containing a second conductive ceramic containing boron carbide as a main constituent material.

2. The thermocouple according to claim 1, wherein a content of the boron carbide is 50 mass% or more in the second conductive ceramic.

3. The thermocouple according to claim 1, wherein a content of the boron carbide is 70 mass% or more in the second conductive ceramic.

4. The thermocouple according to claim 1, wherein the second conductive ceramic contains the boron carbide and unavoidable impurities.

5. The thermocouple according to any one of claims 1 to 4, further comprising an insulating member insulating the first conductive member and the second conductive member from each other in a region other than the temperature sensing junction,
wherein a material for the insulating member contains zirconium oxide and/or zircon.

## Amended claims

### Amended claims under Art. 19.1 PCT

1. (Amended) A thermocouple comprising:
a first conductive member; and
a second conductive member,
the first conductive member and the second conductive member being connected to each other to form a temperature sensing junction,
the first conductive member containing a first conductive ceramic containing zirconium diboride and/or titanium diboride, silicon carbide, a sintering agent, and unavoidable impurities,
a content of the silicon carbide being 5 mass% or more and 40 mass% or less in the first conductive ceramic,
the second conductive member containing a second conductive ceramic containing boron carbide as a main constituent material,
the first conductive member forming a one-end-closed tube,
an open end of the first conductive member being closed by a plug,
the plug having a through-hole formed for introducing the second conductive member from outside to inside of the first conductive member.

2. The thermocouple according to claim 1, wherein a content of the boron carbide is 50 mass% or more in the second conductive ceramic.

3. The thermocouple according to claim 1, wherein a content of the boron carbide is 70 mass% or more in the second conductive ceramic.

4. The thermocouple according to claim 1, wherein the second conductive ceramic contains the boron carbide and unavoidable impurities.

5. The thermocouple according to any one of claims 1 to 4, further comprising an insulating member insulating the first conductive member and the second conductive member from each other in a region other than the temperature sensing junction,
wherein a material for the insulating member contains zirconium oxide and/or zircon.
